# EUROPEAN PATENT APPLICATION

(11) **EP 4 661 604 A1**
(43) Date of publication of application: **10.12.2025**
(21) Application number: 24750256.0
(22) Date of filing: 30.01.2024
(51) Int. Cl.: H05K 1/03, C08J 5/18, C08K 3/013, C08K 9/06, C08L 27/18, C08L 101/00

(54) **DIELECTRIC, COPPER-CLAD LAMINATE, AND METHODS FOR MANUFACTURING SAME**

(30) Priority: 02.02.2023 JP 2023014571; 04.10.2023 JP 2023172981
(71) Applicant: Daikin Industries, Ltd., Osaka-shi, Osaka 530-0001 (JP)
(72) Inventor: OKUNO, Shingo, Osaka-shi, Osaka 530-0001 (JP); UEDA, Yuki, Osaka-shi, Osaka 530-0001 (JP); HOSOKAWA, Moe, Osaka-shi, Osaka 530-0001 (JP); SAWAKI, Kyohei, Osaka-shi, Osaka 530-0001 (JP); TANAKA, Yoshito, Osaka-shi, Osaka 530-0001 (JP); YAMAUCHI, Akiyoshi, Osaka-shi, Osaka 530-0001 (JP); KISHIKAWA, Yosuke, Osaka-shi, Osaka 530-0001 (JP)
(74) Representative: Hoffmann Eitle
(86) International application number: PCT/JP2024/002773
(87) International publication number: WO 2024/162307

(57) **Abstract**

A dielectric that has excellent electrical characteristics and causes no blistering of a copper foil during production of a copper-clad laminate using the dielectric, and a method for producing the same are provided. Further, a copper-clad laminate using the dielectric, and a method for producing the same are provided. A dielectric has a moisture content of 1000 µg/g or less. The metal-clad laminate has the dielectric and a metal foil.

## Description

### Technical Field

The present disclosure relates to a dielectric, a copper-clad laminate and a method for producing the same.

### Background Art

A high-frequency printed wiring board with a low transmission loss has been required. In such a high-frequency printed wiring board, use of a fluororesin compounded with a filler as wiring board material is described in Patent Literature 1 to 3.

### Citation List

### Patent Literature

Patent Literature 1: Japanese Patent Laid-Open No. S63-259907
Patent Literature 2: International Publication No. WO 2021/024883
Patent Literature 3: International Publication No. WO 2021/235460

### Summary of Invention

### Technical Problem

The present disclosure aims to provide a dielectric that has excellent electrical characteristics and causes no blistering of a copper foil during production of a copper-clad laminate using the dielectric, and a method for producing the same. Further, the present disclosure aims to provide a copper-clad laminate using the dielectric, and a method for producing the same.

### Solution to Problem

The present disclosure relates to a dielectric having a moisture content of 1000 µg/g or less.

The dielectric preferably contains a resin and an inorganic filler.

It is preferable that the resin be a fluororesin.

It is preferable that the fluororesin be non melt-processible.

It is preferable that the fluororesin be partially or wholly polytetrafluoroethylene (PTFE).

It is preferable that the polytetrafluoroethylene have a standard specific gravity (SSG) of 2.0 to 2.3.

It is preferable that the inorganic filler be at least one selected from the group consisting of silica, titanium oxide, magnesium oxide, alumina, and forsterite.

It is preferable the inorganic filler be partially or wholly silica.

It is preferable that the content of the silica relative to the total amount of the dielectric be 30 mass% or more.

It is preferable that the resin be polytetrafluoroethylene (PTFE), the filler be silica, and the content of the silica relative to the total amount of the dielectric be 50 mass% or more and 70 mass% or less.

It is preferable that the silica has an average particle size of 0.2 to 10 µm.

It is preferable that the silica has a surface coated with a silane coupling agent.

It is preferable that the fluororesin be a particle and have an average particle size of 0.05 to 1,000 µm.

The present disclosure also relates to a metal-clad laminate having the dielectric and a metal foil.

The present disclosure is also a copper-clad laminate having the dielectric and a copper foil.

It is preferable that at least a surface of the copper foil to be bonded to a dielectric have a surface roughness Rz of 2.0 µm or less.

It is preferable that the copper foil be a rolled copper or an electrolytic copper.

It is preferable that the dielectric has a dielectric tangent value at 10 GHz of 0.0015 or less.

It is preferable that the dielectric has a thickness of 5 to 250 µm.

The present disclosure also relates to a method for producing the dielectric, comprising mixing a fluororesin particle and an inorganic filler, and forming a film.

In the production method, it is preferable that the film be formed using a composition substantially including a fluororesin particle and an inorganic filler.

The present disclosure also relates to a method for producing the copper-clad laminate, comprising laminating a dielectric and a copper foil, heating the laminate in a temperature range of 180 to 390°C, and press forming the laminate in a pressure range of 1 to 100 kN under vacuum or in an inert gas atmosphere.

The present disclosure also relates to a substrate for circuits comprising the dielectric or the copper-clad laminate.

### Advantageous Effects of Invention

The dielectric of the present disclosure has a low dielectric constant and low loss, and has excellent electrical characteristics. Further, in the case of using the dielectric of the present disclosure for production of a copper-clad laminate, no blistering in a copper foil occurs.

### Description of Embodiments

The present disclosure is described in detail as follows.

In the field of high-frequency printed wiring boards, higher levels of performance, such as low dielectric constant and low loss, have been required in recent years. On the other hand, many studies have been conducted on dielectrics compounded with a filler in resins such as fluororesin.

The present disclosure provides a dielectric having excellent electrical characteristics that satisfy performance such as low dielectric constant and low loss with the moisture content in the dielectric controlled in a specific range. The dielectric provided causes no blistering of a copper foil during production of a copper-clad laminate using the dielectric.

With an excessively high moisture content in a dielectric, the electrical characteristics of the dielectric increase. A copper clad laminate containing such a dielectric has a large transmission loss, and is therefore unsuitable as copper clad laminate. In addition, in the case where a dielectric is produced by powder rolling forming from silica with a relatively small particle size as filler, the amount of water absorbed increases in some cases. In the case where a copper clad laminate is produced using the dielectric with a large moisture content, blistering occurs in a copper foil.

In Patent Literatures 1 to 3, use of a hydrophobic filler and decrease in voids in a dielectric are studied in order to reduce the moisture content. However, in Patent Literatures 1 to 3, no specific moisture content in the dielectric layer of a copper clad laminate is disclosed, and the appropriate moisture content in a dielectric has not been fully studied until now.

In the present disclosure, an optimum amount of moisture contained in a dielectric has been found. The dielectric of the present disclosure is characterized in that the moisture content is 1000 µg/g or less.

The moisture content in a dielectric is preferably 500 µg/g or less, and more preferably 400 µg/g or less.

In the present disclosure, the moisture content is a value measured by the following method.

The dielectric cut into a size (40 mm by 50 mm) to be fitted into a boat of each apparatus is placed in the vaporization chamber of a moisture measuring device (CA-200, VA-200, manufactured by Mitsubishi Chemical Corporation) to measure the moisture generated at 250°C under the following conditions.
Electrolytic solution: Hydranal Coulomat AG-OVEN Hydranal CG
Vaporization chamber temperature condition: 250°C
Vaporization chamber nitrogen flow rate: 250 mL/min

In the present disclosure, the lower limit of the moisture content in the dielectric is preferably 50 µg/g, more preferably 100 µg/g, and still more preferably 150 µg/g.

With an excessively low moisture content in a dielectric, the dielectric sheet shape may be hardly maintained, due to difficulty in controlling film formation conditions.

In the present disclosure, the dielectric of which moisture content is to be measured may be a dielectric taken out from a copper-clad laminate including the dielectric and a copper foil that are laminated, by etching the copper foil.

The dielectric of the present disclosure is made from a resin. In the case where the dielectric of the present disclosure is made from a fluororesin, it is preferable that the fluororesin contain an inorganic filler.

### (Resin)

It is preferable that the resin be at least one selected from the group consisting of a fluororesin, polyimide, modified polyimide, liquid crystal polymer (LCP), polyphenylene sulfide, cycloolefin polymer, polystyrene, epoxy resin, bismaleimide, polyphenylene oxide, modified polyphenylene ether, polyphenylene ether, and polybutadiene.

It is preferable that the dielectric of the present disclosure contain a fluororesin. The fluororesin has low dielectric properties and can therefore be suitably used for the purpose of the present disclosure.

### (Fluororesin)

It is preferable that the fluororesin used in the present disclosure be in a particulate form.

It is preferable that the average particle size of the fluororesin particle be 0.05 to 1,000 µm. The lower limit of the average particle size of the fluororesin particle is more preferably 0.07 µm or more, and still more preferably 0.1 µm or more. The upper limit of the average particle size of the fluororesin particle is preferably 700 µm or less, and still more preferably 500 µm or less.

Use of such a particle has an advantage of excellent formability and dispersibility. The average particle size is a value measured in accordance with ASTM D 4895.

It is preferable that the volume-based cumulative 50% size of the fluororesin particle be 0.05 to 40 µm. The lower limit of the volume-based cumulative 50% size of the fluororesin particle is more preferably 0.7 µm or more, and still more preferably 1 µm or more. The upper limit of the volume-based cumulative 50% size of the fluororesin particle is preferably 35 µm or less, and still more preferably 30 µm or less.

Use of such a particle has an advantage of excellent formability and dispersibility. The volume-based cumulative 50% size is a value measured by a laser diffraction-type particle size distribution analyzer.

The fluororesin particle for use in the present disclosure is not limited, and examples thereof include polytetrafluoroethylene (PTFE), tetrafluoroethylene [TFE]/hexafluoropropylene [HFP] copolymer [FEP], TFE/alkyl vinyl ether copolymer [PFA], TFE/HFP/alkyl vinyl ether copolymer [EPA], TFE/chlorotrifluoroethylene [CTFE] copolymer, TFE/ethylene copolymer [ETFE], polyvinylidene fluoride [PVdF], and tetrafluoroethylene with a molecular weight of 300,000 or less [LMW-PTFE]. One type thereof may be used, or two or more types may be mixed.

It is preferable that the fluororesin particle for use in the present disclosure be non melt-processible.

The term "non melt-processible" means that a resin has insufficient fluidity even when heated to the melting point or more, and cannot be molded by melting generally used for resins. PTFE falls into this category.

From the viewpoint of low dielectric properties, PTFE is particularly preferred. PTFE having fibrillation properties is preferred. PTFE having fibrillation properties allows non sintered polymer particles to be paste extruded or formed by powder rolling.

It is preferable that the fluororesin be partially or wholly PTFE.

The modified PTFE contains a TFE unit based on TFE and a modifying monomer unit based on a modifying monomer. The modifying monomer unit is a part of the molecular structure of modified PTFE, which is a part derived from the modifying monomer. The modified PTFE contains a modifying monomer unit in an amount of preferably 0.001 to 0.500 mass%, more preferably 0.01 to 0.30 mass% of the total monomer units. The total monomer units are the part derived from all the monomers in the molecular structure of the modified PTFE.

The modifying monomer is not limited as long as it can be copolymerized with TFE, and examples thereof include perfluoro-olefin such as hexafluoropropylene (HFP); chlorofluoro-olefin such as chlorotrifluoroethylene (CTFE); hydrogen-containing fluoroolefin such as trifluoroethylene and vinylidene fluoride (VDF); perfluoro vinyl ether; and perfluoro alkyl ethylene (PFAE) and ethylene. One type or plural types of modifying monomers may be used.

The perfluoro vinyl ether is not limited, and examples thereof include an unsaturated perfluoro compound represented by the following general formula (1) :

CF₂=CF-ORf ... (1)

wherein, Rf represents a perfluoro organic group.

In the present specification, the perfluoro organic group is an organic group of which all the hydrogen atoms bonded to a carbon atom are replaced with fluorine atoms. The perfluoro organic group may have an ether oxygen.

Examples of the perfluoro vinyl ether include perfluoro(alkyl vinyl ether) (PAVE) with Rf in the general formula (1) being a perfluoroalkyl group having 1 to 10 carbon atoms. The number of carbon atoms of the perfluoroalkyl group is preferably 1 to 5. Examples of the perfluoroalkyl group in PAVE include a perfluoromethyl group, a perfluoroethyl group, a perfluoropropyl group, a perfluorobutyl group, a perfluoropentyl group, and a perfluorohexyl group. As PAVE, perfluoropropyl vinyl ether (PPVE) and perfluoromethyl vinyl ether (PMVE) are preferred.

The perfluoro alkyl ethylene (PFAE) is not limited, and examples thereof include perfluoro butyl ethylene (PFBE), and perfluoro hexyl ethylene (PFHE).

As the modifying monomer in the modified PTFE, at least one selected from the group consisting of HFP, CTFE, VDF, PAVE, PFAE and ethylene is preferred.

In the present disclosure, it is preferable that such a non melt-processable fluororesin be formed into a fluororesin sheet by a forming method including fibrillating the fluororesin. The forming method will be described later.

It is preferable that the PTFE have a standard specific gravity (SSG) of 2.0 to 2.3. From such PTFE, a PTFE film with high strength (cohesion force and piercing strength per unit thickness) tends to be easily obtained. PTFE with a large molecular weight has long molecular chains, so that a structure in which the molecular chains are regularly arranged is hardly formed. In that case, the length of an amorphous portion increases, so that the degree of entanglement among molecules increases. It is presumed that with a high degree of entanglement among molecules, a PTFE film is less likely to deform under an applied load, so that excellent mechanical strength can be exhibited. Further, use of PTFE with a large molecular weight makes it easier to obtain a PTFE film with a small average pore size.

The lower limit of the SSG is more preferably 2.05, and still more preferably 2.1. The upper limit of the SSG is more preferably 2.25, and still more preferably 2.2.

Standard specific gravity (SSG) is measured as follows. A sample is prepared in accordance with ASTM D-4895-89 and the specific gravity of the resulting sample is measured by water displacement method.

It is preferable that the PTFE have a refractive index in the range of 1.2 to 1.6. Having such a refractive index is preferred in terms of low dielectric constant. The refractive index in the range is achieved by a method of adjusting the polarizability or the flexibility of the main chain, and other methods. The lower limit of the refractive index is more preferably 1.25, still more preferably 1.30, and most preferably 1.32. The upper limit of the refractive index is more preferably 1.55, more preferably 1.50, and most preferably 1.45.

The refractive index is a value measured with a refractometer (Abbemat 300).

The particulate PTFE contains a polytetrafluoroethylene resin having a secondary particle size of 500 µm or more in an amount of preferably 50 mass% or more, more preferably 80 mass% or more. With a content of PTFE having a secondary particle size of 500 µm or more in the range, an advantage in terms of producing a mixture sheet with high strength is achieved.

Through use of PTFE with a secondary particle size of 500 µm or more, a mixture sheet with lower resistance and high toughness can be obtained.

The lower limit of the secondary particle size is more preferably 300 µm, and still more preferably 350 µm. The upper limit of the secondary particle size is more preferably 700 µm or less, and still more preferably 600 µm or less. The secondary particle size may be determined, for example, by a sieving method.

Further, it is preferable that the PTFE have a maximum endothermic peak temperature (crystalline melting point) of 340±7°C.

The PTFE may be a low melting point PTFE having a maximum peak temperature of 338°C or less on the endothermic curve of a crystalline melting curve measured by a differential scanning calorimeter, or a high melting point PTFE having a maximum peak temperature of 342°C or more on the endothermic curve of a crystalline melting curve measured by a differential scanning calorimeter.

The low melting point PTFE particle is a particle produced by polymerization by emulsion polymerization method, and has the maximum endothermic peak temperature (crystalline melting point) described above, a dielectric constant (ε) of 2.08 to 2.2, and a dielectric tangent (tan δ) of 1.9×10⁻⁴ to 4.0×10⁻⁴. Examples of the commercially available product include Polyflon Fine Powder F201, F203, F205, F301 and F302 manufactured by Daikin Industries, Ltd., CD090 and CD076 manufactured by AGC Inc., and TF6C, TF62 and TF40 manufactured by DuPont.

The high melting point PTFE particle is also a particle produced by polymerization by emulsion polymerization method, and has the maximum endothermic peak temperature (crystalline melting point) described above, a dielectric constant (ε) of 2.0 to 2.1, and a dielectric tangent (tan δ) of 1.6×10⁻⁴ to 2.2×10⁻⁴, which are generally low. Examples of the commercially available product include Polyflon Fine Powder F104 manufactured by Daikin Industries, Ltd., CD1, CD141 and CD123 manufactured by AGC Inc., and TF6 and TF65 manufactured by DuPont.

It is preferable that the average particle size of the secondary aggregates of both PTFE particles be usually 250 to 2,000 µm. In particular, granulated particles obtained by granulation with a solvent are preferred in terms of improved fluidity during filling a mold in the premolding.

### (Inorganic filler)

The inorganic filler that can be used in the present disclosure is not limited, and examples thereof include one or more inorganic fillers selected from ceramics, talc, mica, alumina, zinc oxide, tin oxide, titanium oxide, silicon oxide, calcium carbonate, calcium oxide, magnesium oxide, potassium titanate, forsterite, glass fiber, glass chips, glass beads, silica, calcium fluoride, boron nitride, barium sulfate, molybdenum disulfide, and potassium carbonate whiskers. Two or more types of these may be used in combination.

Among these, one selected from the group consisting of silica, titanium oxide, magnesium oxide, alumina, and forsterite is particularly preferred. Alternatively, one that contains a combination of these is preferred. In particular, it is preferable that the inorganic filler be partially or wholly silica.

The shape of the inorganic filler is not limited, and examples thereof include spherical and crushed shapes. Among these, a spherical shape is preferred. A spherical shape is preferred in terms of easiness of uniform processing during drilling, and low transmission loss with a small specific surface area.

The spherical inorganic filler means that the particle shape is close to a true sphere. Specifically, the sphericity is preferably 0.80 or more, more preferably 0.85 or more, still more preferably 0.90 or more, and most preferably 0.95 or more. The sphericity is calculated as follows. An SEM photograph of a particle is observed to determine the area and the perimeter of the particle, from which the sphericity is calculated as a value:
(Sphericity)={4π×(Area)/(Perimeter)2}. The closer to 1, the closer to the true sphere. Specifically, an average value measured for 100 particles with an image processing device (FPIA-3000, manufactured by Spectris Co., Ltd.) is employed.

In the present disclosure, it is preferable that the inorganic filler have an average particle size of 0.1 to 10 µm. The average particle size here is a D50 value measured by a laser diffraction-type particle size distribution analyzer. With an average particle size of less than 0.1 µm, due to occurrence of inorganic filler aggregation, insufficient effects tend to be obtained. With an average particle size of more than 10 µm, the sheet tends to be hardly formed into a thin film.

The lower limit of the average particle size is more preferably 0.2 µm, and the upper limit of the average particle size is more preferably 5 µm.

It is preferable that the silica particles used in the present disclosure have an average particle size of 0.2 to 10 µm. With an average particle size of less than 0.2 µm, the amount of water absorbed in the silica particles tends to increase. With an average particle size of more than 10 µm, the sheet is hardly formed into a thin film.

The lower limit of the average particle size is more preferably 0.3 µm, and still more preferably 0.4 µm. The upper limit of the average particle size is more preferably 5 µm, and still more preferably 3 µm.

It is also preferable that the spherical silica particles used in the present disclosure have a D90/D10 of 2 or more (preferably 2.3 or more, 2.5 or more) and a D50 of 10 µm or less in integration of the volume from the smaller particle size. Furthermore, it is preferable that D90/D50 be 1.5 or more (more preferably 1.6 or more). It is preferable that D50/D10 be 1.5 or more (more preferably 1.6 or more). These allow spherical silica particles with a smaller particle size to enter a space among spherical silica particles with a larger particle size, so that excellent filling property and high fluidity can be achieved. In particular, a particle size distribution having a higher frequency on the smaller particle size-side compared to a Gaussian curve is preferred. The particle size can be measured by a laser diffraction scattering-type particle size distribution measurement apparatus. It is also preferable that coarse particles having a predetermined particle size or more be removed using a filter or the like.

The spherical silica has a water absorption of preferably 1.0% or less, more preferably 0.5% or less. The water absorption is based on the mass of the spherical silica when dried. In calculation of the water absorption, a dry sample is left standing at 40°C and 80% RH for 1 hour, and the moisture generated by heating the sample at 200°C is measured using a Karl Fischer moisture meter.

Alternatively, a dielectric sheet may be heated in an air atmosphere at 600°C for 30 minutes to burn off the fluororesin. After the spherical silica particles are taken out, each of the parameters may be measured by the method described above.

The spherical silica for use may be a commercially available silica particle that satisfies the properties described above. Examples of the commercially available silica particle include Denka fused silica FB Grade (manufactured by Denka Co., Ltd.), Denka fused silica SFP Grade (manufactured by Denka Co., Ltd.), Excelica (manufactured by Tokuyama Corporation), high-purity synthetic spherical silica particle Admafine (manufactured by Admatechs Co., Ltd.), Admanano (manufactured by Admatechs Co., Ltd.), and Admafuse (manufactured by Admatechs Co., Ltd.).

The titanium oxide, magnesium oxide, and alumina described above have a higher relative dielectric constant (Dk) than silica, and can be added to adjust the relative dielectric constant (Dk). Examples of the commercially available titanium oxide include CR-EL (manufactured by Ishihara Sangyo Kaisha, Ltd.) and HT0210 (manufactured by Toho Titanium Co., Ltd.). Examples of the commercially available magnesium oxide include RF-10CS and RF-10C-45 µm (manufactured by Ube Material Industries, Ltd.). Examples of commercially available alumina include LS-110F and LS-210B (manufactured by Nippon Light Metal Co., Ltd.).

The inorganic filler, particularly the silica particles, is preferably surface-treated. Being subjected to surface treatment in advance, the inorganic filler, particularly silica particles, can be prevented from aggregation, so that the inorganic filler, particularly silica particles, can be well dispersed in the resin composition.

In order to perform the surface treatment, the type and the amount of surface-treating agent are appropriately selected.

The surface treatment is not limited, and any known one may be used. Specific examples of the treatment include treatment with a silane coupling agent such as epoxysilane, aminosilane, isocyanate silane, vinylsilane, acrylic silane, hydrophobic alkylsilane, phenyl silane, and fluorinated alkylsilane having a reactive functional group, plasma processing, and fluorination treatment.

Specific examples of the silane coupling agent include epoxy silanes such as γ-glycidoxypropyl triethoxysilane and β-(3,4-epoxycyclohexyl)ethyltrimethoxysilane, amino silanes such as aminopropyltriethoxysilane and N-phenylamino propyltrimethoxysilane, isocyanate silanes such as 3-isocyanatepropyltrimethoxysilane, vinyl silanes such as vinyltrimethoxysilane, and acrylic silanes such as acryloxy trimethoxysilane.

In the present disclosure, it is preferable to use silica particles of which surface is coated with a silane coupling agent, among those surface-treated. Through an appropriate surface treatment, the amount of water absorbed in the silica can be reduced.

In the treatment with a silane coupling agent, the amount of silane coupling agent is preferably 3 mass% or less relative to the inorganic filler, particularly to silica particles. With a large amount of silane coupling agent in the treatment, the amount of water absorbed in the inorganic filler, particularly in silica particles, increases, so that a dielectric produced by powder rolling forming has many cracks therein. As a result, the moisture content in the dielectric increases, and during production of a copper-clad laminate, blistering tends to occur in the copper foil.

### (Dielectric)

The dielectric of the present disclosure is made of the resin, and preferably contains an inorganic filler and fluororesin particles described above. If needed, the composition may contain a component other than the inorganic filler and the fluororesin particle, or may solely consist of the inorganic filler and the fluororesin particle. It is preferable that the content of components other than the inorganic filler and the fluororesin particle be 10 mass% or less relative to the total amount of the dielectric.

In particular, it is preferable that the dielectric substantially consist of a fluororesin particle and an inorganic filler. "Substantially consist of fluororesin particle and an inorganic filler" means that the content of components other than the inorganic filler and the fluororesin particle is 3 mass% or less relative to the total amount of the dielectric.

It is preferable that the content of the inorganic filler be 30 mass% or more relative to the total amount of the dielectric. Within such a range, the linear expansion coefficient of the dielectric can be controlled to be low.

It is preferable that the content of silica be 30 mass% or more relative to the total amount of the dielectric.

The lower limit of the inorganic filler content is more preferably 35 mass%, and still more preferably 40 mass%. On the other hand, the upper limit of the inorganic filler content is preferably 70 mass%.

The dielectric of the present disclosure is usually used in a sheet form.

It is preferable that the dielectric have a thickness of 5 to 250 µm. The dielectric of the present disclosure can adequately achieve its purpose even with a thin thickness. From such a viewpoint, the thickness is more preferably less than 200 µm, and still more preferably less than 150 µm.

It is preferable that the dielectric of the present disclosure has a dielectric tangent (Df) at 10 GHz of 0.0015 or less. With a dielectric tangent in the range, the composition is preferred in terms of achieving low dielectric loss.

The upper limit of the dielectric tangent (Df) is more preferably 0.0012, more preferably 0.0011. On the other hand, the lower limit of the dielectric tangent (Df) is preferably 0.00001.

It is preferable that the dielectric of the present disclosure have a relative dielectric constant (Dk) at 10 GHz of 3.5 or less. A relative dielectric constant (Dk) in the range is preferred in terms of having a low dielectric loss.

The upper limit of the relative dielectric constant (Dk) is more preferably 3.2, and still more preferably 3.1. On the other hand, the lower limit of the relative dielectric constant (Dk) is preferably 2.0, and more preferably 2.5.

The relative dielectric constant (Dk) and the dielectric tangent (Df) at 10 GHz in the present specification are determined through measurement of Dk and Df at 25°C and 10 GHz using a split cylinder-type dielectric constant/dielectric tangent measuring device (manufactured by EM labs, Inc.).

It is also preferable that a linear expansion coefficient (CTE) of 100 ppm/K or less. With a linear expansion coefficient in the range, the composition is preferred in terms of producing a dielectric sheet with low shrinkage and excellent dimensional stability. The upper limit of the linear expansion coefficient (CTE) is more preferably 70 ppm/K, and still more preferably 50 ppm/K. On the other hand, the lower limit of the linear expansion coefficient (CTE) is more preferably 5 ppm/K, and still more preferably 10 ppm/K.

The linear expansion coefficient in the present specification is determined by performing TMA measurement in a tensile mode using a TMA-7100 (manufactured by Hitachi High-Tech Science Corporation). A sheet is cut into a length of 20 mm and a width of 5 mm as a sample piece. The chuck distance is set to 10 mm. While applying a load of 49 mN at a heating rate of 2°C/min, the linear expansion coefficient is determined from the amount of displacement of the sample at 0 to 150°C.

### (Production method of dielectric)

The dielectric of the present disclosure may be obtained by mixing the fluororesin particle and the inorganic filler, and forming a film. The present disclosure also relates to a production method of a derivative including mixing a fluororesin particle and an inorganic filler to form a film.

The production may be performed by paste extrusion forming or powder rolling forming, though the production method thereof not being limited thereto. Among these, paste extrusion forming is preferred.

As described above, it is preferable that a non melt-processible fluororesin be employed as the fluororesin for use in the dielectric of the present disclosure. In the case of using such a fluororesin, it is preferable that particulate PTFE as raw material be fibrillated to achieve forming into a sheet shape.

The specific method for paste extrusion forming and powder rolling forming are not limited, and usual methods thereof are described as follow.

### (Paste extrusion forming)

The method for producing the sheet may include, for example, a step (1a) of mixing a PTFE powder obtained by using a hydrocarbon surfactant, an inorganic filler and an extrusion auxiliary agent, a step (1b) of paste extruding forming the resulting mixture, a step (1c) of rolling the extrudate resulting from extrusion forming, a step (1d) of drying the sheet after rolling, and a step (1e) of sintering the dried sheet to obtain a formed article.

Conventionally known additives such as a pigment and a filler may be added to the fluororesin particle to perform the paste extrusion forming.

As the extrusion auxiliary agent, a usually known one may be used without a particular limitation. Example thereof include a hydrocarbon oil.

In a step (1e) of sintering the dried sheet to obtain a formed article, it is suitable that the sintering temperature be controlled to 350°C or more and 380°C or less, and the sintering time be controlled to 15 minutes or more and 1 hour or less, for reduction of the moisture content in the dielectric.

### (Powder rolling forming)

Powder rolling forming is a method of applying a shear force to a resin powder to be fibrillated, so that forming into a sheet shape is achieved. The method may include subsequent sintering of the powder to obtain a formed article.

More specific examples of the production method include: a step (1) of applying a shear force to a raw material composition containing a fluororesin particle and a filler while mixing; a step (2) of forming the mixture obtained in the step (1) into a bulk form; and a step (3) of rolling the mixture in the bulk form obtained in the step (2) into a sheet form.

The production method may further include: a step (4) of sintering the resulting product in a sheet form at 200 to 400°C for 1 to 60 minutes.

Alternatively, the step (2) may be omitted.

In step (4) of sintering the sheet form product at 200 to 400°C for 1 to 60 minutes, it is suitable that the sintering temperature be 350°C or more and 380°C or less, and the sintering time be 15 minutes or more and 1 hour or less, in order to reduce the moisture content in the dielectric.

In the case where a sheet is produced by the powder rolling forming, it is preferable that a composition substantially consisting of a fluororesin particle and an inorganic filler be used for film formation.

Alternatively, it is preferable that a fluororesin particle and an inorganic filler only be mixed for the forming.

### (Other resins)

Examples of the liquid crystal polymer (LCP) include a thermoplastic liquid crystal polyester, and a thermoplastic liquid crystal polyester amide, which is produced by introducing an amide bond into the thermoplastic liquid crystal polyester. Alternatively, the liquid crystal polymer may be a polymer, which is produced by further introducing a bond such as an imide bond, a carbonate bond, a carbodiimide bond or a bond derived from isocyanate such as an isocyanate bond, to an aromatic polyester or an aromatic polyester amide. Also, a polymer having a rigid structure such as naphthoic acid is preferred.

Polyimide is a general term of polymers that include an imide bond in an repeating unit. Usually, the polyimide may be an aromatic polyimide in which aromatic compounds are directly bonded through an imide bond.

Modified polyimide is a polymer that includes an imide bond in a repeating unit with reduced water absorption of polyimide.

Polyphenylene sulfide is a crystalline thermoplastic resin having a simple linear chain structure in which a benzene ring (p-phenylene group) and a sulfur atom (sulfide bond) are alternately bonded.

Cycloolefin polymer is a polymer having a cyclic structure in the polymer chain, which may be subjected to ring-opening metathesis polymerization and coordination polymerization.

Polystyrene is a polymer obtained by polymerizing styrene, including syndiotactic polystyrene with controlled stereoregularity to impart crystallinity.

Epoxy resin is a thermosetting synthetic resin having a reactive epoxy group at an end. The most typical epoxy resin is a copolymer of bisphenol A and an epichlorohydrin. As a curing agent, various polyamines and acid anhydrides are used.

Bismaleimide resin is a high-performance thermosetting addition polyimide, which can be usually synthesized by producing bismaleimide through condensation of phthalic anhydride and an aromatic diamine at a molar ratio of 2:1, and through subsequent Michael addition of even more diamines to the double bond at an end of bismaleimide.

Polyphenyleneoxide is a thermoplastic resin produced from 2,6-disubstituted phenol through oxidation coupling polymerization.

Polyphenylene ether (PPE) is a resin made of a blend of polyphenylene oxide (PPO) and polystyrene, having impact resistance at low temperature, together with toughness and rigidity.

Polyphenylene ether is a plastic characterized by heat resistance, flame retardance, chemical resistance, etc.

Modified polyphenylene ether is a general term of polymer alloy produced by mixing polyphenylene ether (PPE) as an amorphous engineering plastic and another resin, having excellent hydrolysis resistance due to the ether-bonded benzene ring in the main chain.

Polybutadiene is a type of general-purpose synthetic rubber produced by polymerizing 1,3-butadiene, having excellent elasticity, abrasion resistance, and low-temperature characteristics.

Examples of the method for forming sheets made of a resin other than the fluororesins include melt extrusion forming, cast forming, inflation forming, calendar molding, cast molding, vacuum/pressure forming, compression forming and press forming. In each forming method, the moisture content can be reduced through control of the forming temperature and forming time.

In a method for forming a sheet made of a resin other than fluororesin, forming a composition containing the resin alone or containing the resin and an inorganic filler is preferred.

### (Thermal compression forming)

It is preferable that the method for producing a liquid crystal polymer film include at least a heat treatment step of heat-treating a laminate in which both sides of a liquid crystal polymer film are sandwiched between a pair of heat-resistant releasable supports under a predetermined pressure at a temperature of (HT+15) to (HT+70)°C, wherein HT is heat distortion temperature of the thermoplastic liquid crystal polymer film before the heat treatment step, and a peeling step of peeling the pair of heat-resistant releasable supports off from the laminate to obtain a thermoplastic liquid crystal polymer film.

In the heat treatment step, the liquid crystal polymer film obtained by extrusion forming (e.g., inflation method or the like) is used, and a laminate in which both sides of the liquid crystal polymer film are sandwiched between a pair of heat-resistant releasable supports is heat-treated at a desired temperature under a desired pressure. In the heat treatment, the liquid crystal polymer molecules on the front and back sides present in a skin layer are supposed to be subjected to a shear force. As a result, the dielectric constant in the thickness direction of the liquid crystal polymer film after the heat treatment step can be controlled to a desired range. In addition, in the heat treatment step, the moisture content in the liquid crystal polymer can be reduced.

The heat-resistant releasable supports disposed on both sides of the liquid crystal polymer film may be of the same type or different types as long as the purpose can be achieved, though the same type is preferred.

### (Copper-Clad Laminate)

The dielectric of the present disclosure may be laminated with another substrate for use as a sheet for a substrate for circuits.

The present disclosure also relates to a metal-clad laminate having a dielectric described above and a metal foil.

Examples of the metal include copper, stainless steel, aluminum, iron, silver, gold and ruthenium. Further, an alloy thereof is also usable. In particular, copper is preferred.

The present disclosure also relate to a copper-clad laminate having the dielectric described above and a copper foil. The copper-clad laminate may include a copper foil bonded to one or both sides of the dielectric described above. As described above, the dielectric containing the fluororesin of the present disclosure is particularly suitably used for a substrate for circuits, and therefore can be suitably used as such a copper-clad laminate.

It is preferable that the dielectric in the copper-clad laminate has a dielectric tangent (Df) at 10 GHz of 0.0015 or less. Such a range is preferred in terms of low dielectric loss.

The upper limit of the dielectric tangent (Df) is more preferably 0.0012, and still more preferably 0.0011. On the other hand, it is preferable that the lower limit of the dielectric tangent (Df) be 0.00001.

It is preferable that the dielectric in a copper-clad laminate has a thickness of 5 to 250 µm. The dielectric of the present disclosure can sufficiently achieve the purpose even having a thin thickness. From the viewpoint, a thickness of less than 200 µm is more preferred, and a thickness of less than 150 µm is still more preferred.

It is preferable that the copper foil have a surface roughness Rz of 2.0 µm or less. The dielectric of the present disclosure has excellent adhesion to a copper foil having a high smoothness with Rz of 2.0 µm or less. Furthermore, the copper foil needs only to have Rz of 2.0 µm or less on at least the surface to be bonded to the dielectric, and the Rz value is not limited on surfaces that are not bonded to the fluororesin sheet.

The Rz is the sum of a value at the highest point (maximum peak height: Rp) and a value at the deepest point (maximum valley depth: Rv). The surface roughness is the ten-point average roughness specified in JIS-B0601. In the present specification, the Rz is a value measured for a measurement length of 4 mm by a surface roughness meter (trade name: Surfcom 470A, manufactured by Tokyo Seimitsu Co., Ltd.).

The thickness of the copper foil is not limited, preferably in the range of 1 to 100 µm, more preferably in the range of 5 to 50 µm, and still more preferably 9 to 35 µm.

The copper foil is not limited, and specific examples thereof include a rolled copper foil and an electrolytic copper foil.

The copper foil with Rz of 2.0 µm or less is not limited, and a commercially available product may be used. Examples of the commercially available copper foil with Rz of 2.0 µm or less include an electrolytic copper foil CF-T9DA-SV-18 (thickness: 18 µm, Rz: 0.85 µm) (manufactured by Fukuda Metal Foil and Powder Co., Ltd.) and an electrolytic copper foil CF-V9S-SV-18 (thickness: 18 µm, Rz: 1.5 µm) (manufactured by Fukuda Metal Foil and Powder Co., Ltd.).

The copper foil may be surface-treated to increase the adhesion strength with the dielectric of the present disclosure.

The copper-clad laminate of the present disclosure may further have a layer other than the copper foil and the dielectric.

In the copper-clad laminate of the present disclosure, the copper foil layer may be formed on one or both sides of the sheet in a roll shape. Examples of the method for forming the copper foil layer include laminating (adhering) a copper foil to the surface of the sheet in a roll shape, vapor deposition, and plating. Examples of the method for laminating copper foil include hot pressing. Examples of the hot pressing temperature include a temperature in the range from the melting point of the dielectric sheet - 150°C to the melting point of the dielectric sheet + 40°C. The hot pressing time period is, for example, 1 to 30 minutes. The hot pressing pressure in the production method may be 0.1 to 10 MPa.

The present disclosure also relates to a method for producing a copper-clad laminate, comprising laminating a dielectric and a copper foil, heating the laminate in a temperature range of 180 to 390°C, and press forming the laminate in a pressure range of 1 to 100 kN under vacuum or in an inert gas atmosphere.

The press forming under such conditions also allows adhesion to a copper foil without deterioration of the dielectric.

The use of the copper-clad laminate of the present disclosure is not limited, and the copper-clad laminate is suitably used as a substrate for circuits. The present disclosure also relates to a substrate for circuits having the copper-clad laminate described above.

The substrate for circuits is a plate-shaped component for electrically connecting electronic components such as semiconductors and capacitor chips, while disposing and fixing them in a limited space at the same time. The configuration of the substrate for circuits formed from the derivative or copper-clad laminate is not limited. The substrate for circuits may be any of a rigid circuit board, a flexible circuit board, and a rigid-flexible circuit board. The substrate for circuits may be any of a single-sided board, a circuit board, a double-sided circuit board, and a multilayer circuit board (such as a built-up circuit board). In particular, the substrate for circuits can be suitably used for flexible circuit boards and rigid circuit boards. In particular, the substrate for circuits can be suitably used as a high-frequency printed circuit board of 10 GHz or more.

The production method of the substrate for circuits is not limited, and the substrate for circuits may be produced from the copper-clad laminate described above by a conventional method.

Examples

The present disclosure is specifically described with reference to Examples as follows. In the following Examples, unless otherwise specified, "part" and "%" represent "part by mass" and "mass%", respectively.

### (Example 1 to Example 3, Example 5 to Example 9, Example 11, Example 13)

### (Paste extrusion forming)

Each of the fluororesin particle (PTFE)and silica was weighed, such that the silica content was the amount shown in Table 1, and mixed in a mixer in the presence of dry ice. The temperature during mixing was -10°C or less.

To the resulting mixture, an oil (Isopar H) was added in amount of 18 to 23% and mixed. The mixture was aged for about 5 hours.

The aged composition was preformed under conditions at a pressure of 3 MPa, and the preformed article was extruded under conditions at 40°C and 50 mm/min to obtain an extrusion sample.

The extrusion sample was rolled with two rolls (roll space: set to 500 to 80 µm) to obtain a sample with a film thickness of 125 µm, which was dried at 200°C for 2 hours, and sintered at 360°C for 20 minutes to obtain a dielectric sheet.

The fluororesin particle (PTFE) for use in each Example had the following properties.
Average particle size: 500 µm
Apparent density: 460 g/L
Standard specific gravity: 2.17

The silica for use in each example was, as shown in Table 1, as spherical silica, SC6500-SQ (average particle size: 2.1 µm) manufactured by Admatechs, SC6500-SQ (average particle size: 2.1 µm) manufactured by Admatechs, which was surface-treated with 3-aminopropyltriethoxysilane (treatment amount in Examples 3 to 5 and Examples 10 and 11: 1 mass%, treatment amount in Comparative Example 2: 10 mass%), or SC2500-SQ (average particle size: 0.5 µm) manufactured by Admatechs, as crushed silica, ZA-30 manufactured by Tatsumori Ltd., or ZA-30 manufactured by Tatsumori Ltd., which was surface-treated with a mixture of phenyltrimethoxysilane and aminoethyl aminopropyltrimethoxysilane at a ratio of 9:1 in a treatment amount of 1 mass%.

### (Example 4, Example 12)

### (Powder rolling forming)

The fluororesin particle (PTFE) and silica were weighed in prescribed amounts in the proportion shown in Table 1, and stirred for 30 seconds twice at room temperature with a Wonder Crusher at memory 6. The resulting powder was rolled with two rolls (roll space: set to 100 µm, roll temperature: 100°C) to obtain a sample with a film thickness of 130 µm, which was sintered at 360°C for 20 minutes to obtain a dielectric sheet.

### (Comparative Example 1 to Comparative Example 2)

### (Powder rolling forming)

The fluororesin powder (PTFE) and silica each were weighed out such that the silica content was as shown in Table 1, and stirred for 30 seconds twice at room temperature with a Wonder Crusher at memory 6.

The resulting mixture was rolled with two rolls (roll space: set to 100 µm, roll temperature: 100°C) to obtain a sample with a film thickness of 130 µm, which was sintered at 360°C for 15 minutes to obtain a dielectric sheet.

In Comparative Example 1, fine spherical silica (UFP-30 manufactured by Denka Co., Ltd. (average particle size: 0.1 µm)) was used.

Each of the resulting dielectric sheets was evaluated based on the following criteria.

### [Moisture content]

The dielectric sheet cut into a size (40 mm by 50 mm) to be fitted into a boat of each apparatus was placed in the vaporization chamber of a moisture measuring device (CA-200, VA-200, manufactured by Mitsubishi Chemical Corporation) to measure the moisture generated at 250°C under the following conditions.
Electrolytic solution: Hydranal Coulomat AG-OVEN Hydranal CG
Vaporization chamber temperature condition: 250°C
Vaporization chamber nitrogen flow rate: 250 mL/min

### [Dk and Df]

Dk and Df at 25°C and 10 GHz were measured using a split cylinder-type dielectric constant/dielectric tangent measuring device (manufactured by EM labs, Inc.).

### [CTE (Linear expansion coefficient)]

TMA measurements were performed in a tensile mode using a TMA-7100 (manufactured by Hitachi High-Tech Science Corporation). A sheet cut into a length of 20 mm and a width of 5 mm was used as a sample piece. The chuck distance was set to 10 mm, and the CTE (linear expansion coefficient) was determined from the amount of displacement of the sample at a heating rate of 2°C/min from 0 to 150°C while applying a load of 49 mN.

### (Production of copper-clad laminate)

Each of the dielectric sheets obtained in Examples 1 to 9, Examples 11 to 13 and Comparative Examples 1 to 2 was put between two sheets of electrolytic copper foil CF-V9S-SV-18 (thickness: 18 µm, Rz: 1.5 µm) (manufactured by Fukuda Metal Foil and Powder Co., Ltd.), heated at 360°C, press-formed at a pressure of 15 kN under vacuum for 5 minutes, and cooled to room temperature to obtain a copper-clad laminate.

Each of the resulting copper-clad laminates was evaluated based on the following criteria.

### [Appearance of copper-clad laminate]

From the copper-clad laminate produced, a test piece with a size of 100 mm by 100 mm was cut out. Through visual observation of the test piece, a test piece with blistering identified at one or more places was viewed as occurrence of blistering, and a test piece with no blistering identified was viewed as good.

These results are shown in Table 1.

### (Example 10)

The copper-clad laminate in Example 5 was etched by the following method, and the moisture content of the collected dielectric layer was measured.

### (Etching)

The copper foil of the copper-clad laminate was etched with an aqueous solution of ferric chloride, cleaned with running clean water for 2 to 5 minutes, further cleaned with distilled water, and dried in a constant-temperature vessel at 80±3°C for about 60 minutes to collect a dielectric layer as simple substance.

The results are shown in Table 1.

### (Example 14)

A copolymerized product of p-hydroxy benzoic acid and 6-hydroxy-2-naphthoic acid (molar ratio: 70/30) was melt-extruded to obtain a thermoplastic liquid crystal polymer film having a melting point of 325°C, a heat distortion temperature of 280°C, and a film thickness of 100 µm through inflation forming.

As a heat-resistant releasable support, a polyimide film (linear expansion coefficient: 16 ppm/K) having a thickness of 100 µm was used. Both of the surfaces of the resulting thermoplastic liquid crystal polymer film was put between the two polyimide films, with the MD direction and the TD direction of the two polyimide films arranged in the same directions, so that a laminate was produced. The laminate was preheated with a vacuum heat press, and heat-treated at 330°C for 15 minutes under a pressure of 3 MPa. After the heat treatment, from the laminate cooled and taken out, the polyimide films were peeled away to obtain a dielectric sheet.

The resulting dielectric sheet was evaluated based on the criteria described above.

The dielectric sheet was put between two sheets of electrolytic copper foil CF-V9S-SV-18 (thickness: 18 µm, Rz: 1.5 µm) (manufactured by Fukuda Metal Foil and Powder Co., Ltd.), press-formed under conditions at 170°C and 3 MPa for 60 minutes, under vacuum, and cooled to room temperature to obtain a copper-clad laminate.

The resulting copper-clad laminates were each evaluated based on the criteria described above.

The results are shown in Table 1.

**[Table 1]**

| | Forming method | Type of silica | Surface treatment with silica coupling agent | Amount of silica | Vacuum press temperature | Moisture content | Dk(10GHz) | Df(10GHz) | CTE | Appearance of copper-clad |
|---|---|---|---|---|---|---|---|---|---|---|
| | | | | (%) | (°C) | (µg/g) | | | (ppm/K) | laminate |
| Example 1 | Paste extrusion | SC6500-SQ | - | 50 | 360 | 177 | 2.70 | 0.0007 | 70 | good |
| Example 2 | Paste extrusion | SC6500-SQ | - | 60 | 360 | 195 | 277 | 0.0007 | 50 | good |
| Example 3 | Paste extrusion | SC6500-SQ | 3-aminopropyl ethoxysilane (1%) | 50 | 360 | 160 | 2.59 | 0.0006 | 60 | good |
| Example 4 | Powder rolling | SC6500-SQ | 3-aminopropyl ethoxysilane (1%) | 50 | 360 | 210 | 2.59 | 0.0006 | 60 | good |
| Example 5 | Paste extrusion | SC6500-SQ | 3-aminopropyl ethoxysilane (1%) | 60 | 360 | 220 | 2.89 | 0.0007 | 33 | good |
| Example 6 | Paste extrusion | SC2500-SQ | - | 50 | 360 | 181 | 2.68 | 0.0019 | 63 | good |
| Example 7 | Paste extrusion | SC2500-SQ | - | 60 | 360 | 200 | 2.70 | 0.0022 | 31 | good |
| Example 8 | Paste extrusion | ZA-30 | - | 50 | 360 | 195 | 2.44 | 0.0063 | 43 | good |
| Example 9 | Paste extrusion | ZA-30 | Mixture of phenyltrimethoxysilane and aminoethyl aminopropyltrimethoxysilane at a ratio of 9:1 (1%) | 50 | 360 | 233 | 2.72 | 0.0019 | 46 | good |
| Example 10 | Paste extrusion | SC6500-SQ | 3-aminopropyl ethoxysilane (1%) | 60 | 360 | 185 | 2.89 | 0.0007 | 33 | good |
| Example 11 | Paste extrusion | SC6500-SQ | 3-aminopropyl ethoxysilane (1%) | 70 | 360 | 184 | 2.84 | 0.0008 | 25 | good |
| Example 12 | Powder rolling | SC6500-SQ | 3-aminopropyl ethoxysilane (1%) | 70 | 360 | 270 | 2.84 | 0.0008 | 28 | good |
| Example 13 | Paste extrusion | SC6500-SQ | - | 70 | 360 | 220 | 2.87 | 0.0010 | 28 | good |
| Example 14 | Inflation | - | - | - | 170 | 480 | 2.91 | 0.0021 | 21 | good |
| Comparative Example 1 | Powder rolling | UFP-30 | - | 70 | 360 | 1240 | 2.45 | 0.0093 | 25 | occurrence of blistering |
| Comparative Example 2 | Powder rolling | SC6500-SQ | 3-aminopropyl ethoxysilane (10%) | 70 | 360 | 1050 | 285 | 0.0030 | 30 | occurrence of blistering |

The results show that the dielectric of the present disclosure makes good appearance of a copper-clad laminate.

### Industrial Applicability

The dielectric disclosed herein is particularly suitable for use in a high-frequency printed circuit board.

## Claims

1. A dielectric, having a moisture content of 1,000 µg/g or less.

2. The dielectric according to claim 1, comprising a resin and an inorganic filler.

3. The dielectric according to claim 2, wherein the resin is a fluororesin.

4. The dielectric according to claim 3, wherein the fluororesin is non melt-processible.

5. The dielectric according to claim 3 or 4, wherein the fluororesin is partially or wholly polytetrafluoroethylene (PTFE).

6. The dielectric according to claim 5, wherein the polytetrafluoroethylene (PTFE) has a standard specific gravity (SSG) of 2.0 to 2.3.

7. The dielectric according to any one of claims 2 to 6, wherein the inorganic filler is at least one selected from the group consisting of silica, titanium oxide, magnesium oxide, alumina and forsterite.

8. The dielectric according to any one of claims 2 to 6, wherein the inorganic filler is partially or wholly silica.

9. The dielectric according to claim 8, wherein a content of the silica relative to a total amount of the dielectric is 30 mass% or more.

10. The dielectric according to claim 8 or 9, wherein the silica has an average particle size of 0.2 to 10 µm.

11. The dielectric according to any one of claims 8 to 10, wherein the silica has a surface coated with a silane coupling agent.

12. The dielectric according to any one of claims 3 to 11, wherein the fluororesin includes particles having an average particle size of 0.05 to 1,000 µm.

13. The dielectric according to claim 2, wherein the resin is polytetrafluoroethylene (PTFE), the inorganic filler is silica, and a content of the silica relative to a total amount of the dielectric is 50 mass% or more and 70 mass% or less.

14. A metal-clad laminate comprising the dielectric according to any one of claims 1 to 13 and a metal foil.

15. A copper-clad laminate comprising the dielectric according to any one of claims 1 to 13 and a copper foil.

16. The copper-clad laminate according to claim 15, wherein at least a surface of the copper foil to be bonded to a dielectric has a surface roughness Rz of 2.0 µm or less.

17. The copper-clad laminate according to claim 15 or 16, wherein the copper foil is a rolled copper or an electrolytic copper.

18. The copper-clad laminate according to any one of claims 15 to 17, wherein the dielectric has a dielectric tangent value at 10 GHz of 0.0015 or less.

19. The copper-clad laminate according to any one of claims 15 to 18, wherein the dielectric has a thickness of 5 to 250 µm.

20. A method for producing the dielectric according to any one of claims 1 to 13, comprising mixing a fluororesin particle and an inorganic filler, and forming a film.

21. The method for producing the dielectric according to claim 20, wherein the film is formed using a composition substantially consisting of a fluororesin particle and an inorganic filler.

22. A method for producing the copper-clad laminate according to any one of claims 15 to 19, comprising laminating a dielectric and a copper foil, heating the resulting laminate in a temperature range of 180 to 390°C, and press forming the laminate in a pressure range of 1 to 100 kN, under vacuum or in an inert gas atmosphere.

23. A substrate for circuits comprising the dielectric according to any one of claims 1 to 13 or the copper-clad laminate according to any one of claims 15 to 19.
